# EUROPÄISCHE PATENTSCHRIFT

(11) **EP 0 357 591 B1**
(45) Veröffentlichungstag und Bekanntmachung des Hinweises auf die Patenterteilung: **08.11.1995**
(21) Anmeldenummer: 89890220.0
(22) Anmeldetag: 28.08.1989
(51) Int. Cl.: H03F 3/70

(54) **Ladungsverstärkerschaltung**
Charge amplifier circuit
Circuit amplificateur de charge

(30) Priorität: 02.09.1988 AT 2171/88
(43) Veröffentlichungstag der Anmeldung: 07.03.1990
(73) Patentinhaber: AVL Gesellschaft für Verbrennungskraftmaschinen und Messtechnik mbH.Prof.Dr.Dr.h.c. Hans List, 8020 Graz (AT)
(72) Erfinder: Krempl, Peter, Dr., A-8047 Kainbach 211 (AT); Wegscheider, Günther, A-8020 Graz (AT); Wöss, Gerhard, Dipl.-Ing., A-8043 Graz (AT)
(74) Vertreter: Pinter, Rudolf, Dipl.-Ing.

(56) Entgegenhaltungen:
- EP-A- 0 080 234
- DE-A- 3 330 043
- US-A- 4 555 953
- INSTRUMENTS AND EXPERIMENTAL TECHNIQUES, Band 20, Nr. 4, Juli/August 1977,Seiten 1071-1073, New York, US; A.A. ANTONOVSKII et al.: "Electrometeramplifier"
- IEEE TRANSACTIONS ON NUCLEAR SCIENCE, Band NS-13, Nr. 1, Februar 1966, Seiten611-622, New York, US; A.E. BRADLEY: "Design for a versatile charge sensitivepreamplifier for nuclear radiation detectors"
- M.Seifart, Analoge Schaltungen, VEB Verlag Technik, Berlin, 1987, Seiten 330-333

## Beschreibung

Die Erfindung betrifft eine Ladungsverstärkerschaltung, mit einer Operationsverstärkerstufe, deren Signalausgang über ein Rückkopplungsglied mit einem, endlichen Widerstand aufweisenden Kondensator zum Signaleingang rückgekoppelt ist.

Ladungsverstärkerschaltungen der genannten Art sind in einer Vielzahl von Ausführungen bekannt und haben wesentlich zur heute breiten Anwendung der piezoelektrischen Meßtechnik beigetragen, da damit die dem Elektrometerverstärker anhaftenden Mängel eliminiert werden konnten. Die Operationsverstärkerstufe ist als Gleichstromverstärker mit möglichst hoher innerer Spannungsverstärkung ausgeführt, wobei die Polarität der Ausgangsspannung derjenigen der Eingangsspannung entgegengesetzt und ein möglichst hoher Eingangswiderstand realisiert ist. Dieser Verstärker ist mit einem hoch isolierenden Kondensator (entsprechend einem parallelen RC-Glied) kapazitiv gegengekoppelt, wodurch die Eingangsimpedanz praktisch auf Null gebracht wird, der hohe Isolationswiderstand am Eingang jedoch erhalten bleibt. Unter Annahme idealer Verhältnisse folgt damit, daß über die Kapazität angeschlossener Meßwertaufnehmer, Kabel und dergleichen keine Spannung entsteht, sodaß der Isolationswiderstand im Eingangskreis unkritisch ist und die Eingangskapazität keinen Einfluß auf die Ausgangsspannung hat. Weiters ist die Ausgangsspannung direkt proportional zu der von einem Meßwertaufnehmer oder dergleichen abgegebenen Ladung und damit auch zur eigentlich zu bestimmenden Meßgröße, sowie umgekehrt proportional zur Gegenkopplungskapazität, sodaß durch Einschalten entsprechender Kapazitätswerte auf einfache Weise beliebig gestufte Meßbereiche erreicht werden können.

Unter Berücksichtigung der realen Gegebenheiten (die innere Verstärkung der Operationsverstärkerstufe ist nicht unendlich sondern auf Werte im Bereich von 10⁵ bis 10⁷ begrenzt; als Isolationswiderstand sind sowohl am Verstärkereingang wie auch für die Rückkopplungskondensatoren nur maximal etwa 100 TΩ möglich; es gibt keine Eingangsstufen, welche absolut keinen Leckstrom aufweisen; und dergleichen) ergeben sich jedoch gewisse Nachteile im Hinblick auf das Meßverfahren bzw. den Aufbau der Schaltung, die sich insbesonders im Zusammenhang mit genauen bzw. empfindlichen Messungen oder quasistatischen Messungen sehr störend bemerkbar machen können. Einer der wesentlichsten dieser Nachteile liegt in dem Umstand begründet, daß das zur kapazitiven Rückkopplung der Operationsverstärkerstufe dienende RC-Glied (ob das R bewußt durch einen zusätzlichen, parallel zum Kondensator liegenden, entsprechenden Widerstand oder aber nur durch den Innenwiderstand des Kondensators bestimmt ist, ist dabei belanglos) eine Knickfrequenz im Übertragungsverhalten der Ladungsverstärkerschaltung bedingt, die im Interesse eines möglichst linearen Übertragungsverhaltens und im Hinblick darauf, daß sehr niedrige Frequenzen bei den üblichen Meßaufgaben derartiger Anordnungen ohnedies außer Betracht bleiben können, mit gewissem Sicherheitsabstand unterhalb des Arbeitsfrequenzbereiches angesiedelt wird. Damit ergibt sich unmittelbar die Notwendigkeit, das Produkt R.C der Operationsverstärker-Rückkopplung möglichst groß zu machen. Da ein Anstieg der Größe des Rückkopplungskondensators die Ladungsempfindlichkeit der Schaltung praktisch umgekehrt proportional herabsetzt, bleibt nur die Möglichkeit, den Widerstand im Rückkopplungskreis möglichst hoch zu machen. Gemäß heutigem Stande der Technik sind, wie erwähnt, in diesem Zusammenhang Widerstandswerte von maximal etwa 100 TΩ realisierbar - dies allerdings auch nur unter günstigsten Bedingungen und Zuhilfenahme sorgfältiger händischer Nachbearbeitung beim Schaltungsaufbau. Abgesehen davon, daß diese hohen Widerstandswerte nicht ohne weiters reproduzierbar bzw. dauerhaft sind, ergeben sich damit auch Nachteile im Hinblick auf das bei höheren Widerstandswerten immer höhere Widerstandsrauschen sowie im Hinblick auf die Abhängigkeit der Ladungs-Spannungsübertragung der Operationsverstärkerstufe vom Verhältnis zwischen Gegenkopplungswiderstand und Eingangswiderstand (zu diesem, für die vorliegende Erfindung relevanten Stande der Technik siehe beispielsweise auch "Tichy, Gautschi: Piezoelektrische Meßtechnik; Springer-Verlag, Berlin, Heidelberg, New York, 1980"; insbesonders Kapitel 12).

Aufgabe der vorliegenden Erfindung ist es, eine Ladungsverstärkerschaltung der eingangs genannten Art so auszubilden, daß die genannten Nachteile vermieden werden und daß insbesonders auf einfache Weise eine Möglichkeit geschaffen wird, möglichst große Arbeitsfrequenzbereiche bei hoher Ladungsempfindlichkeit und einfacher Realisierbarkeit der Schaltungsanordnung zu erhalten.

Dies wird gemäß der vorliegenden Erfindung dadurch erreicht, daß der Signalausgang der Operationsverstärkerstufe mit dem Eingang einer nachgeschalteten weiteren Übertragungsstufe in Verbindung steht, welche zumindest in der Nähe der durch das Rückkopplungsglied der Operationsverstärkerstufe bestimmten Knickfrequenz f_{I} (= 1/(2πrRC)) eine proportional-integrierende Übertragungscharakteristik mit einer Knickfrequenz f_{II}, welche zumindest annähernd gleich der Knickfrequenz f_{I} ist, aufweist und daß die beiden Knickfrequenzen f_{I}, f_{II} oberhalb des hauptsächlich interessierenden Arbeitsfrequenzbereiches liegen. Durch diese einfache und - wie nachfolgend auch noch anhand von bevorzugten Ausführungsbeispielen erläutert - leicht zu realisierende Ausbildung ist unmittelbar erreicht, daß die Lage der durch das Rückkopplungs-RC-Glied der Operationsverstärkerstufe des eigentlichen Ladungsverstärkers bestimmten Knickfrequenz f_{I} relativ zum Arbeitsfrequenzbereich völlig unkritisch ist, sodaß sowohl R als auch C in der Rückkopplung der Operationsverstärkerstufe in weiten Grenzen beliebig und voneinander unabhängig optimiert festgelegt werden können. Mit einem entsprechend kleinen Wert für C kann also beispielsweise eine hohe Ladungsempfindlichkeit der Ladungsverstärkerschaltung bewirkt werden, wie sie zur Messung kleiner Ladungen erwünscht ist, ohne daß damit im Gegenzug der Wert für R entsprechend in die Höhe gehen müßte. So können bei der erfindungsgemäßen Ladungsverstärkerschaltung die Widerstandswerte R im Rückkopplungskreis der Operationsverstärkerstufe ohne weiteres auf Werte bis zu etwa 100 kΩ begrenzt werden, was den Vorteil hat, daß sich derartige Widerstände problemlos genau realisieren und reproduzieren lassen. Weiters ist bei einem Wert für R der kleiner oder nur um wenige Größenordnungen größer als der Eingangswiderstand der Operationsverstärkerstufe bzw. der Isolationswiderstand des angeschlossenen Ladungsgenerators bzw. der Signalzuleitung ist, die Ladungs-Spannungsübertragung der Operationsverstärkerstufe unabhängig von den zwischen den Eingängen derselben liegenden effektiven Widerständen und Kapazitäten (= Isolationswiderstände, Kabelkapazitäten). Da das durch den Widerstand R - ob bewupt realisiert oder durch die endlichen Isolationswerte bewirkt - verursachte Widerstandsrauschen um so kleiner ist, je kleiner der Wert von R ist, ist naturgemäß ein Widerstand beispielsweise im kΩ-Bereich insbesonders zur Messung kleiner Ladungen wesentlich vorteilhafter. Schließlich kann noch durch die in weiten Grenzen freie Wahl der Knickfrequenz f_{I} der bei herkömmlichen Ladungsverstärkerschaltungen durch den Rückkopplungskondensator der Operationsverstärkerstufe verursachte Nachkriecheffekt stark unterdrückt werden, sodaß sich insgesamt mit der erfindungsgemäßen Schaltungsanordnung auf einfachste Weise ein Ladungsverstärker verwirklichen läßt, der im Hinblick auf Empfindlichkeit, nutzbaren Arbeitsfrequenzbereich, Linearität, Aufbau und Herstellung den herkömmlichen Anordnungen bei weitem überlegen ist.

Die beiden Knickfrequenzen f_{I}, f_{II} liegen gemäß der Erfindung oberhalb des hauptsächlich interessierenden Arbeitsfrequenzbereiches; ob dies innerhalb oder außerhalb des maximal möglichen Frequenzbereiches ist, ist aus den oben angeführten Gründen dabei belanglos. Damit ist sichergestellt, daß unter Umständen zufolge von nicht vollkommen abgeglichenen Schaltungselementen oder dergleichen verbleibende geringfügige Linearitätsabweichungen im Bereich der Knickfrequenzen ohne unmittelbare Auswirkung auf die Messung bleiben. Zudem ist damit das Produkt R.C klein, was die obenstehend bereits ausführlich besprochenen Vorteile im Hinblick auf den Schaltungsaufbau ergibt.

Die nachgeschaltete Übertragungsstufe weist gemäß einer bevorzugten Ausgestaltung der Erfindung eine weitere Operationsverstärkerstufe auf, deren Ausgang über einen in Serie mit einem Widerstand R₁ geschalteten Kondensator C₁ auf den Eingang rückgekoppelt ist. Dies ergibt eine sehr einfache analoge Ausführung der nachgeschalteten Übertragungsstufe, die mit sehr geringem Aufwand eine Ladungsverstärkerschaltung ergibt, die alle genannten Vorteile der Erfindung aufweist und zudem äuperst preisgünstig realisierbar ist.
Zumindest die weitere Operationsverstärkerstufe der nachgeschalteten Übertragungsstufe kann dabei gemäß einer weiteren Ausbildung der Erfindung zusammen mit der Operationsverstärkerstufe und dem Rückkopplungskondensator C monolitisch integriert ausgeführt sein, wobei der Kondensator C₁ und einer der beiden Widerstände R, R₁ als Abstimmwiderstand extern verbunden sind. Der einzig wesentliche Grund, warum bis zum heutigen Tage Ladungsverstärker nicht als IC ausführbar waren, liegt in der eingangs angesprochenen Problematik der extrem hohen Widerstände im Rückkopplungskreis der Operationsverstärkerstufe begründet. Da sich mit der erfindungsgemäßen Ausbildung diese Widerstände auf problemlos auch integriert beherrschbare Größen reduzieren lassen, kann nun die genannte sehr vorteilhafte Ausbildung der Ladungsverstärkerschaltung realisiert werden. Soferne für verschiedene Zwecke eine nachträgliche Abstimmung nicht erforderlich ist, kann natürlich auch die gesamte Ladungsverstärkerschaltung inklusive R₁ und C₁ in einem IC ausgeführt werden.

Die nachgeschaltete Übertragungsstufe kann gemäß einer weiteren Ausgestaltung der Erfindung in digitaler Schaltungstechnik aufgebaut sein, bzw. kann dann auch entsprechend der obengenannten Ausbildung zusammen mit der Operationsverstärkerstufe monolitisch integriert ausgeführt sein. Bei analog realisierter nachgeschalteter Übertragungsstufe ist zufolge des begrenzten Isolationswiderstandes des Rückkopplungskondensators C₁ diese "proportional-integrierende" Übertragungsstufe eigentlich ein phasenabsenkendes Glied (LAG), welches auch als allgemein rationales Übertragungsglied erster Ordnung bezeichnet werden kann. Bei der hier angesprochenen digitalen Realisierung der nachgeschalteten Übertragungsstufe kann jedoch ohne weiteres ein ideales PI-Glied über den gesamten Arbeitsfrequenzbereich ausgeführt werden, was für verschiedene Anwendungen Vorteile bietet.

Nach einer für verschiedene Anwendungen äußerst vorteilhaften weiteren Ausbildung der Erfindung ist vorgesehen, daß zwischen der Operationsverstärkerstufe und der nachgeschalteten Übertragungsstufe eine Offsetdrift-Kompensationseinrichtung zwischengeschaltet ist. Derartige Kompensationseinrichtungen sind an sich beispielsweise aus der AT-PS 377.132 bzw. auch aus der EP-A1 253 016 bekannt und erlauben - üblicherweise während der einzelnen Meßphasen - eine Kompensation der Nullpunktabweichung des Meßsignals.

Die Erfindung wird im folgenden noch anhand der in der Zeichnung schematisch dargestellten Ausführungsbeispiele und Signaldiagramme näher erläutert.
Die Fig. 1 bis 5 zeigen dabei Beispiele für erfindungsgemäße Ladungsverstärkerschaltungen und die
Fig. 6 und 7 zeigen die Sprungantworten bzw. das Signalübertragungsverhalten der Operationsverstärkerstufe einerseits und der nachgeschalteten Übertragungsstufe andererseits.

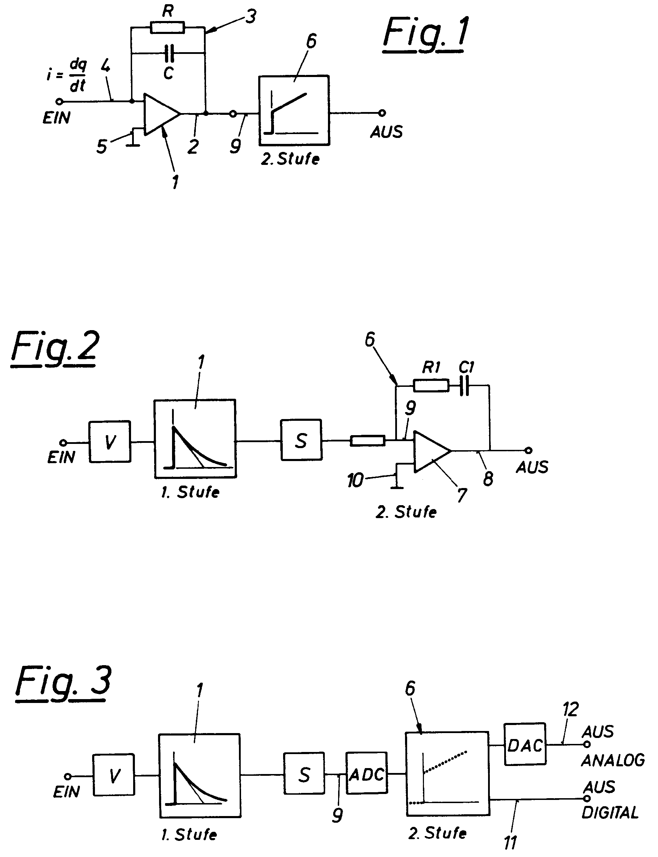

Fig. 1 zeigt das Prinzipbild einer erfindungsgemäßen Ladungsverstärkerschaltung, mit einer Operationsverstärkerstufe 1, deren Signalausgang 2 über ein paralleles Rückopplungs-RC-Glied 3 zum Signaleingang 4 rückgekoppelt ist. Der weitere Eingang 5 der Operationsverstärkerstufe 1 liegt an Masse.

Die Operationsverstärkerstufe 1 ist hier in invertierender Ausführung dargestellt; es ist für die Zwecke der vorliegenden Erfindung jedoch belanglos, ob es sich um eine invertierend oder nicht invertierend geschaltete Operationsverstärkerstufe handelt. Der Vollständigkeit halber ist hier ebenfalls darauf hinzuweisen, daß sämtliche der Fig. 1 bis 5 nur schematisch die jeweiligen Schaltungen mit den die Funktionen beschreibenden Teilen zeigen - Bias-, Versorgungs- und Sicherungsschaltungen und dergleichen sind der Einfachheit halber bzw. zur Verbesserung der Übersichtlichkeit weggelassen.

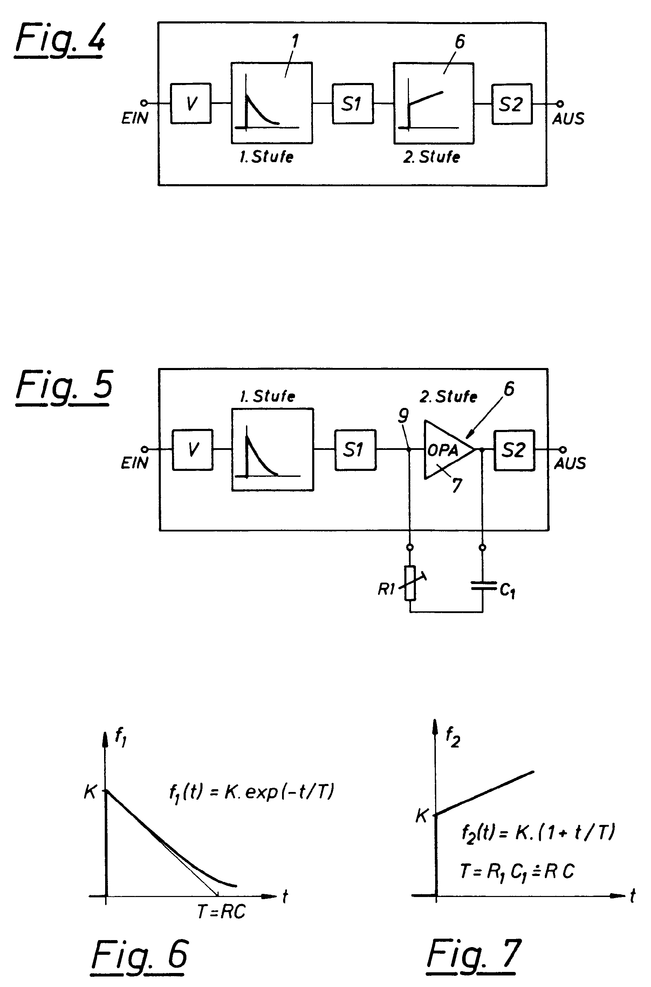

Die nachgeschaltete, weitere Übertragungsstufe 6 ist in Fig. 1 als zweite Stufe bezeichnet und nur mit ihrer charakteristischen Sprungantwort symbolisch dargestellt. Die Sprungantwort eines PI (proportional-integrierenden) -Gliedes ist auch in Fig. 7 dargestellt. Der Anstieg der Geraden für t > 0 ist gleich K/T, wobei K ein Proportionalitätsfaktor ist. Die Zeitkonstante T bestimmt die eingangs mehrmals angesprochene Knickfrequenz des PI-Gliedes und wird beispielsweise bei den in den Fig. 2 und 5 dargestellten analogen Ausführungen durch R₁.C₁ bestimmt. Diese Zeitkonstante soll zumindest annähernd gleich dem R.C der ersten Stufe - also der Operationsverstärkerstufe 1 - sein; d.h. es soll gelten R.C = R₁.C₁.

In Fig. 2 ist nun die Operationsverstärkerstufe 1 gemäß Fig. 1 nur mehr mit ihrer typischen Sprungantwort dargestellt und als erste Stufe bezeichnet. Die nachgeschaltete weitere Übertragungsstufe bzw. zweite Stufe ist wiederum mit 6 bezeichnet und in analoger Ausführung dargestellt. Sie besteht im wesentlichen aus einer weiteren Operationsverstärkerstufe 7, deren Ausgang 8 über einen in Serie mit einem Widerstand R₁ geschalteten Kondensator C₁ auf den Eingang 9 rückgekoppelt ist. Der weitere Eingang 10 des Operationsverstärkers 7 liegt wiederum auf Masse. Auch hier gilt bezüglich der Ausbildung als invertierender oder nicht invertierender Operationsverstärker bzw. weiterer Elemente wiederum das oben zu Fig. 1 bereits ausgeführte.

Das mit S bezeichnete Schaltungsglied kann z.B. eine Offsetdrift-Kompensationseinrichtung zur Minimierung der Offsetspannungsdrift darstellen. Im allgemeinen steht das mit S bezeichnete Schaltungsglied hier und in den weiteren Figuren aber für jegliche Signalkonditionierung. Mit V ist eine Einrichtung zur Vorkonditionierung des Eingangssignals (beispielsweise zur Eingangsabsicherung etc.) angedeutet.

Bezüglich der Werte von R₁ und C₁ in Fig. 2 bzw. der dadurch bestimmten Knickfrequenz der nachgeschalteten weiteren Übertragungsstufe gilt wiederum das oben bereits ausgeführte.

In Fig. 3 ist die Operationsverstärkerstufe bzw. erste Stufe 1 wiederum wie in Fig. 2 nur über die Sprungantwort angedeutet. Die nachgeschaltete, weitere Übertragungsstufe bzw. zweite Stufe 6 ist hier digital realisiert. Nach der ersten Stufe wird das Signal zunächst noch analog weiter konditioniert, was im Schaltungsglied S erfolgt. Dieses Glied S kann hier vorteilhafterweise z.B. sowohl eine Verstärkung als auch ein Aliasing-Filter beinhalten. Daran schließt ein Analog-Digital-Konverter (ADC) an. Das digitale PI-Glied bzw. die nachgeschaltete Übertragungsstufe 6 ist hier wie erwähnt durch die punktierte Sprungantwort angedeutet. Je nach Ausführungsart der Ladungsverstärkerschaltung kann diese Stufe dann direkt an einen Digital-Ausgang 11 gehen, oder es wird - gegebenenfalls zusätzlich - über einen Digital-Analog-Konverter (DAC) am Ausgang 12 ein analoges Ausgangssignal bereitgestellt.

Fig. 4 zeigt eine vollständig monolitisch integrierte Ausführung des Ladungsverstärkers, wobei die Operationsverstärkerstufe bzw. erste Stufe 1 ebenso wie die nachgeschaltete Übertragungsstufe bzw. zweite Stufe 6 nur mit ihrer typischen Sprungantwort angedeutet sind. Mit V ist wiederum eine Einrichtung zur Vorkonditionierung des Eingangssignals bezeichnet. Die mit S1 bezeichnete Einrichtung kann eine Zwischenverstärkungs-, Regelungs- bzw. Filterfunktion aufweisen. Die Einrichtung S2 kann eine Ausgangssignalkonditionierung (ADC, DAC, Formatierung, etc.) beinhalten. Ob die weitere Übertragungsstufe bzw. zweite Stufe 6 analog oder aber digital realisiert ist, ist hier belanglos.

In Fig. 5 ist eine teilweise monolitisch integriert ausgebildete Ausführung der Ladungsverstärkerschaltung dargestellt, bei der die nachgeschaltete weitere Übertragungsstufe 6 analog ausgeführt ist und bei welcher zur Erzielung einer großen Zeitkonstanten des Gesamtsystems, welche vom Kondensator C₁ und dem parallel dazu wirkenden Isolationswiderstand bestimmt wird, der Kondensator C₁ und der abstimmbare Widerstand R₁ extern zugeschaltet werden.

Die Fig. 6 und 7 zeigen wie erwähnt die typischen Sprungantworten der Operationsverstärkerstufe bzw. ersten Stufe (Fig. 6) und der nachgeschalteten, weiteren Übertragungsstufe bzw. zweiten Stufe (Fig. 7) samt den in diesem Zusammenhang bedeutsamen Berechnungsformeln.

## Patentansprüche

1. Ladungsverstärkerschaltung, mit einer Operationsverstärkerstufe, deren Signalausgang über ein Rückkopplungsglied mit einem, endlichen Widerstand aufweisenden Kondensator zum Signaleingang rückgekoppelt ist, **dadurch gekennzeichnet**, daß der Signalausgang (2) der Operationsverstärkerstufe (1) mit dem Eingang (9) einer nachgeschalteten, weiteren Übertragungsstufe (6) in Verbindung steht, welche zumindest in der Nähe der durch das Rückkopplungsglied (3) der Operationsverstärkerstufe (1) bestimmten Knickfrequenz f_{I} (=1/(2πRC)) eine proportional-integrierende Übertragungscharakteristik mit einer Knickfrequenz f_{II}, welche zumindest annähernd gleich der Knickfrequenz f_{I} ist, aufweist, und daß die beiden Knickfrequenzen f_{I}, f_{II} oberhalb des hauptsächlich interessierenden Arbeitsfrequenzbereiches liegen.

2. Schaltung nach Anspruch 1, dadurch gekennzeichnet, daß die nachgeschaltete Übertragungsstufe (6) eine weitere Operationsverstärkerstufe (7) aufweist, deren Ausgang (8) über einen in Serie mit einem Widerstand (R₁) geschalteten Kondensator (C₁) auf den Eingang (9) rückgekoppelt ist.

3. Schaltung nach einem der Ansprüche 1 oder 2, dadurch gekennzeichnet, daß zumindest die weitere Operationsverstärkerstufe (7) der nachgeschalteten Übertragungsstufe (6) zusammen mit der Operationsverstärkerstufe (1) und dem Rückkopplungskondensator (C) monolitisch integriert ausgeführt ist, wobei der Kondenstor (C₁) und einer der beiden Widerstände (R, R₁) als Abstimmwiderstand extern verbunden sind.

4. Schaltung nach Anspruch 1 oder 2, dadurch gekennzeichnet, daß die nachgeschaltete Übertragungsstufe (6) in digitaler Schaltungstechnik aufgebaut ist.

5. Schaltung nach Anspruch 4, dadurch gekennzeichnet, daß die nachgeschaltete Übertragungsstufe (6) zusammen mit der Operationsverstärkerstufe (1) monolitisch integriert ausgeführt ist.

6. Schaltung nach einem der Ansprüche 1 bis 5, dadurch gekennzeichnet, daß zwischen der Operationsverstärkerstufe (1) und der nachgeschalteten Übertragungsstufe (6) eine Offsetdrift-Kompensationseinrichtung (S) zwischengeschaltet ist.

## Claims

1. Charge amplifier circuit with an operational amplifier stage of which the output is fed back to the input through a capacitor having a finite resistance, characterised in that the output (2) of the operational amplifier stage (1) is connected to the input (9) of a following further conversion stage (6) which, at least in the neighbourhood of the roll-off frequency f_{I} (=1/(2πRC)) determined by the feedback component (3) of the operational amplifier stage (1), has a proportional-integral conversion characteristic with a roll-off frequency f_{II} which is at least approximately equal to the roll-off frequency f_{I}, and that the two roll-off frequencies f_{I}, f_{II} lie above the working frequency range which is principally of interest.

2. Circuit according to claim 1, characterised in that the following conversion stage (6) comprises a further operational amplifier stage (7) of which the output (8) is fed back to the input (9) through a capacitor (C₁) connected in series with a resistor (R₁).

3. Circuit according to one of claims 1 or 2, characterised in that at least the further operational amplifier stage (7) of the following conversion stage (6) is in a form monolithically integrated with the operational amplifier stage (1) and the feedback capacitor (C), the capacitor (C₁) and one of the two resistors (R, R₁) as a trimming resistor being connected externally.

4. Circuit according to claim 1 or 2, characterised in that the following conversion stage (6) is constructed in digital form.

5. Circuit according to claim 4, characterised in that the following conversion stage (6) is monolithically integrated with the operational amplifier stage (1).

6. Circuit according to one of claims 1 to 5, characterised in that an offset drift compensation device (S) is interposed between the operational amplifier stage (1) and the following conversion stage (6).

## Revendications

1. Circuit amplificateur de charge, avec un étage amplificateur opérationnel dont la sortie de signal est ramenée pour couplage à l'entrée de signal par l'intermédiaire d'un élément de rétroaction, avec un condensateur présentant une résistance finale, caractérisé en ce que la sortie de signal (2) de l'étage amplificateur opérationnel (1) est reliée à l'entrée (9) d'un étage de transfert (6) supplémentaire mis en circuit en aval qui présente, au moins à proximité de la fréquence de coupure f_{I} (=1/ (2πRC)), déterminée par l'élément de contre-réaction (3) de l'étage amplificateur opérationnel (1), une caractéristique de transfert de type proportionnel-intégral avec une fréquence de coupure f_{II}, au moins à peu près égale à la fréquence f_{I}, et en ce que les deux fréquences de coupure f_{I}, f_{II} se situent au-dessus de la plage de fréquence de travail principalement intéressante.

2. Circuit selon la revendication 1, caractérisé en ce que l'étage de transfert (6) mis en circuit en aval présente un étage amplificateur opérationnel (7) supplémentaire dont la sortie (8) est branchée en contre-réaction sur l'entrée (9) par l'intermédiaire d'un condensateur (C₁) mis en circuit en série avec une résistance (R₁).

3. Circuit selon l'une des revendications 1 ou 2, caractérisé en ce qu'au moins l'étage amplificateur opérationnel (7) supplémentaire de l'étage de transfert (6) branché en aval est de réalisation intégrée monolithique, conjointement avec l'étage amplificateur opérationnel (1) et le condensateur de contre-réaction (C), le condensateur (C₁) et l'une des deux résistances (R, R₁) étant reliés en externe, à titre de résistance de réglage.

4. Circuit selon la revendication 1 ou 2, caractérisé en ce que l'étage de transfert (6) mis en circuit en aval est construit selon la technique des circuits numériques.

5. Circuit selon la revendication 4, caractérisé en ce que l'étage de transfert (6) branché en aval est réalisé en technologie intégré monolithique conjointement avec l'étage amplificateur opérationnel (1).

6. Circuit selon l'une des revendications 1 ou 5, caractérisé en ce qu'entre l'étage amplificateur opérationnel (1) et l'étage de transfert (6) mis en circuit en aval est interposé en circuit un dispositif de compensation de dérive du décalage (offset) (S).
